# EUROPEAN PATENT SPECIFICATION

(11) **EP 0 677 923 B1**
(45) Date of publication and mention of the grant of the patent: **23.04.2003**
(21) Application number: 95300992.5
(22) Date of filing: 16.02.1995
(51) Int. Cl.: H03J 7/06, H04N 7/00, H04N 5/455, H04N 11/00

(54) **Demodulating system for high-definition television receiver**
Demodulationsanordnung für einen hochauflösenden Fernsehempfänger
Agencement de démodulation pour un récepteur de télévision à haute résolution

(30) Priority: 12.04.1994 KR 9407632
(43) Date of publication of application: 18.10.1995
(73) Proprietor: LG ELECTRONICS INC., Seoul (KR)
(72) Inventor: Park, Hee Bok, Kungpo-si, Kyungki-do (KR)
(74) Representative: Cross, Rupert Edward Blount

(56) References cited:
- US-A- 2 797 314
- US-A- 4 091 410
- US-A- 4 755 762
- US-A- 5 111 287
- US-A- 5 283 653

## Description

### Background of the Invention

The present invention relates to a high-definition television receiver, and more particularly, to a demodulating system for a high-definition (HD) television receiver.

In the vestigial side band (VSB) system which is selected for United States HD television transmission system format, a frequency and phase locked loop (FPLL) is used for the synchronization of carrier.

The FPLL is to recover the frequency and phase of a carrier selected by a tuner out of a plurality of radio frequency (RF) signals received via an antenna. The carrier recovered by the FPLL is used for a loop-controlling signal for converting the RF signals received to the tuner into signals of a low band.

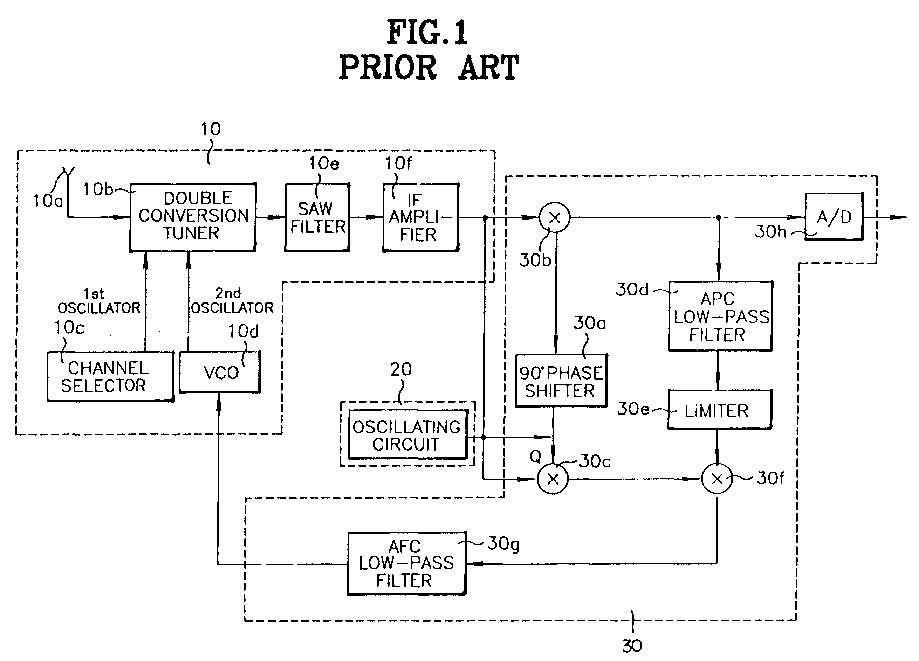

Fig.1 is a block diagram of an HDTV demodulating system used by America's Zenith co., Ltd.

Referring to Fig.1, the system roughly comprises a tuning circuit 10 for selecting one out of a plurality of RF signals and converting the selected carrier into an intermediate frequency signal according to an input loop-controlling signal, an oscillating circuit 20 for generating a sine signal, and a FPLL 30 for giving to tuning circuit 10, the loop-controlling signal for synchronizing the phase and frequency of the intermediate frequency signal including the carrier selected and output from tuning circuit 10 with the phase and frequency of the sine wave output from oscillating circuit 20, using a predetermined algorithm.

In Fig.1, tuning circuit 10 is made up of an antenna 10a for receiving a plurality of RF signals, a double conversion tuner 10b, a channel selector 10c for serving as a first oscillator for, according to a user's selection, selecting one of the RF signals received by double conversion tuner 10b and converting the selected carrier into a first intermediate frequency signal, a voltage controlled oscillator (VCO) 10d for serving as a second oscillator for converting the first intermediate frequency signal into a second intermediate frequency signal of a frequency band easy to handle in a general circuit, a SAW filter 10e for filtering the second intermediate frequency signal output via tuner 10b, and an amplifier 10f for amplifying the second intermediate frequency signal output from SAW filter 10e.

FPLL 30 comprises a phase shifter 30a for shifting the phase of the sine wave output from oscillating circuit 20 by a predetermined angle (here, 90°), a multiplier 30b for multiplying the second intermediate frequency signal output from tuning circuit 10 by the output signal of phase shifter 30a and outputting the multiplication result as I-channel beat signal, a multiplier 30c for multiplying the sine wave signal output from oscillating circuit 20 by the second intermediate frequency signal output from tuning circuit 10 and outputting the result as Q-channel beat signal, an automatic filtering control (AFC) low-pass filter 30d for passing only a predetermined low band of a signal out of the I-channel beat signal and changing the phase of the signal according to the frequency of the I-channel beat signal, a limiter 30e for amplifying and limiting the output signal of AFC low-pass filter 30d to a predetermined amplification degree, a multiplier 30f for multiplying the output signal of multiplier 30c by the output signal of limiter 30e, and an automatic phase control (APC) low-pass filter 30g for passing only a predetermined low frequency band of signal out of the output signal of multiplier 30f and providing the passed signal to VCO 10d of tuning circuit 10, as a loop-controlling signal for correcting the frequency of a selected carrier into an intended frequency.

In Fig.1, FPLL 30 may further comprise an analog-to-digital (A/D) converter 30h for converting the I-channel signal output from I-channel multiplier 30b into a digital signal and sending it to other channel block.

The operation of the demodulating system of Fig.1 will be described in detail.

Out of a plurality of RF signals received via antenna 10a, one carrier is selected by channel selector 10c in double conversion tuner 10b and converted into a first intermediate frequency (IF) signal.

The first IF is designed to fall within a frequency band which does not interfere with other RF channel signals.

The first IF signal is converted into a second IF signal by the second oscillator, VCO 10d, via an amplifier and band-pass filter (not shown) of double conversion tuner 10b.

The second IF frequency signal has a frequency band easy to handle in a general circuit, and does not interfere with other RF channel signals, even though greatly amplified and filtered.

In this case, the IF frequency band is used because, in detecting the RF signal as a low-band signal, as compared with the case where the RF signal is directly converted into a low-band signal, the case where the RF signal is first converted into an IF signal and filtered and amplified, and then converted into the low-band signal, reduces distortion to a video signal.

The second IF signal output from double conversion tuner 10b is converted into an appropriate form via SAW filter 10e and IF amplifier 10f. The IF signal carrier is multiplied by the sine wave output from the final oscillator, oscillating circuit 20, in multipliers 30b and 30c of FPLL 3, and then converted into a low-band signal.

FPLL 30 generates two channel signals, that is, I-channel signal and Q-channel signal. They have a predetermined phase difference (here, 90°).

The I-channel signal out of low-band signals is digitalized by A/D converter 30h and output to other channel block for video data detection.

In order to conform the I-channel signal to the low-band signal sent from a transmission side, a broadcasting station, the frequency and phase of the sine wave output from HDTV oscillator 20 must coincide precisely with the frequency and phase of the final signal of the IF signal carrier selected and output from tuning circuit 10.

One way to conform their frequencies and phases is to fix one between the sine wave of oscillating circuit 20 and the IF signal carrier, and then change the other.

Fig.1 chooses a method in which oscillating circuit 20 is fixed as a reference oscillator and the frequency and phase of the IF signal carrier is changed.

In order to change the frequency and phase of the final IF signal carrier, the oscillating frequency of VCO 10d for forming the second IF signal is changed.

The movement direction and magnitude of the oscillating frequency of VCO 10d can be obtained by operating the FPLL for generating the I-channel signal and Q-channel signal which are both low-band signals, according to an appropriate algorithm.

To find the direction and magnitude is the purpose of FPLL 30. Hereinafer, the operation of FPLL 30 will be described.

If the frequency of the final IF carrier signal is not the same as that of the sine wave output from oscillating circuit 20, a reference oscillator, a beat corresponding to the difference between the two frequencies is large at a low band.

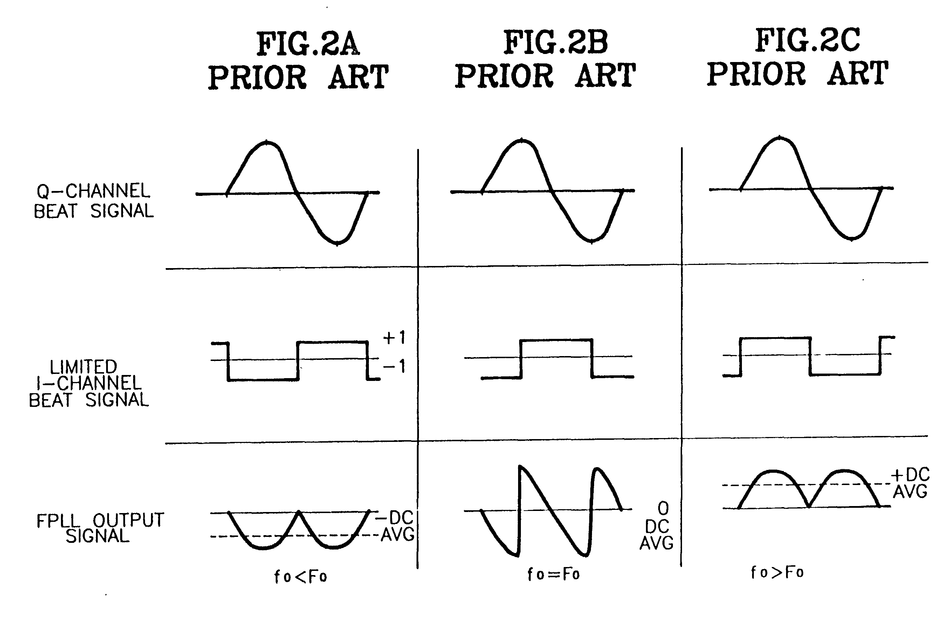

The sine wave of oscillating circuit 20 has a phase difference of 90° in I-channel multiplier 30b and Q-channel multiplier 30c according to phase shifter 30a, and multiplied by the final IF signal. As a result, the I-channel beat signal and Q-channel beat signal have the phase difference of 90°. Here, let's suppose the Q-channel beat signal is a waveform shown at the top of Figs.2A, 2B and 2C.

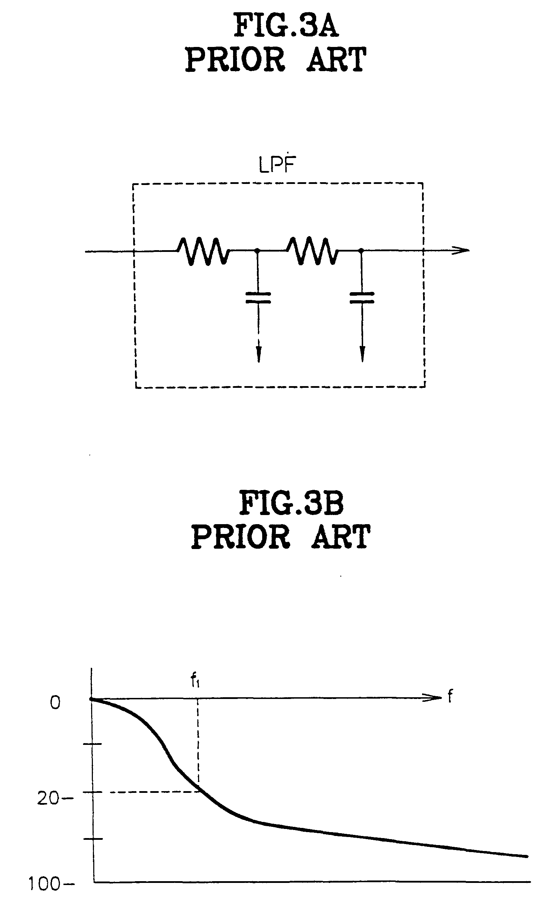

The I-channel beat signal passes AFC low-pass filter 30d having the circuit configuration of Fig.3A and characteristic of Fig.3B. The AFC low-pass filter functions to change phase according to the frequency of the I-channel beat signal.

As shown in Fig.3B, if the I-channel beat signal has frequency f₁, its phase is shifted by 90°.

When the output signal of AFC low-pass filter 30 is amplified and limited through limiter 30e, its waveforms correspond to those of the middle of Figs.2A, 2B and 2C.

Multiplier 30f of FPLL 30 multiplies the waveforms at the top of Figs.2A, 2B and 2C and the waveforms in the middle thereof, to thereby output waveforms lying at the bottom of Figs.2A, 2B and 2C.

The signals output from multiplier 30f are input to VCO 10d of tuning circuit 10 via APC low-pass filter 30g, to thereby correct their oscillating frequencies to intended frequencies.

The output signal of APC low-pass filter 30g corresponding to the waveforms at the bottom of Figs.2A, 2B and 2C is the output signal of FPLL 30 and called a loop-controlling signal.

Given that the frequency of the sine wave output from oscillating circuit 20 is F₀ and the frequency of the final IF signal carrier of the selected carrier is f₀, Fig.2A shows waveforms in the case when f₀ < F₀. Fig.2B shows waveforms in the case when f₀ ≅ F₀. Fig.2C shows waveforms in the case when f₀ > F₀.

FPLL 30 will be explained more in detail.

If f₀ and F₀ are approximate values, since the frequency f₁ of the I-channel beat signal is very small, the phase shift of the signal output from APC low-pass filter 30d is very little.

Therefore, the I-channel beat signal and Q-channel beat signal maintain the phase difference of 90° as in the initial state. Multiplier 30f for multiplying the Q-channel beat signal by the limited I-channel beat signal provides the FPLL output signal whose average is "0" as the loop-controlling signal as in Fig.2A.

If F₀ - f₀ = f₁ ≠ 0, that is, in a frequency synchronization process, phase shifts in the positive direction in proportion to frequency difference f₁ in AFC low-pass filter 30d. Here, the FPLL output signal is the same as Fig.2A.

If F₀ - f₀ = -f₁ ≠ 0, that is, in another frequency synchronization process, phase shifts in the negative direction in proportion to frequency difference f₁. The output signal of FPLL 30 is as shown in Fig.2C.

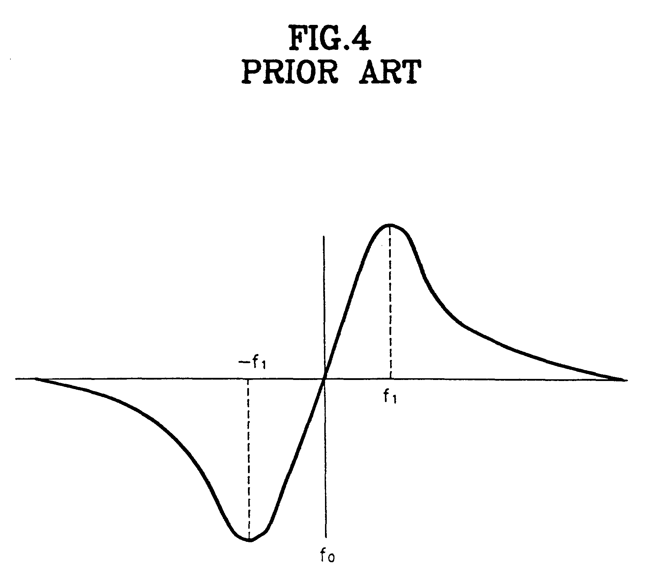

As a result, the FPLL output draws "S" curve as shown in Fig.4 according to the frequency variation of the I-channel beat signal. Here, the central point of "S" curve is F₀ = f₀.

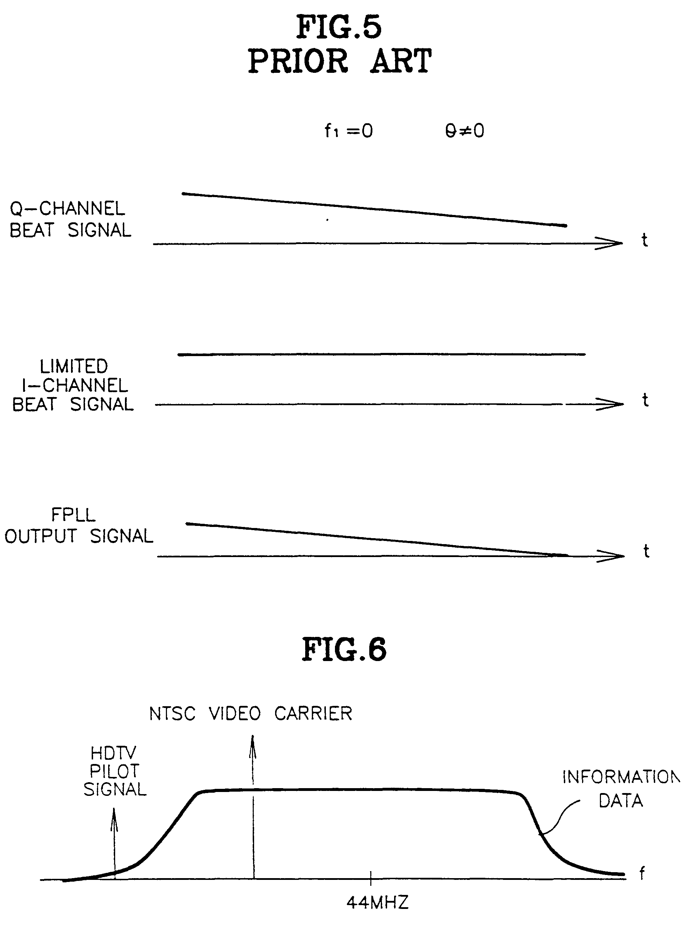

If F₀ and f₀ have the same frequencies but different phases, in the phase synchronization process, as shown in Fig.5, the limited I-channel beat signal maintains value "1" and the Q-channel beat signal has a value proportional to the magnitude of phase difference θ.

The Q-channel loop of Fig.1 has the same characteristic as a general PLL loop and acts to reduce phase difference θ.

The output signal of FPLL 30 converges to "0" as shown in Fig.5.

As described above, FPLL 30 of the demodulating system of Fig.1 use the beat signals of the sine wave of oscillating circuit 20, a reference oscillator, and the selected carrier, so as to extract a loop-controlling signal for synchronizing the frequency and phase of the carrier and reference sine wave.

However, since the IF signal contains general information data as well as carrier, it is difficult to extract clear I-channel beat signal and Q-channel beat signal as in the waveforms at the top of Figs.2A, 2B and 2C. Their averages have such waveforms.

HDTV broadcasting is standardized to simulcast with the conventional NTSC broadcasting. In this condition, if there is an interference of NTSC broadcasting signal commonly using the HDTV broadcasting channel, as shown in Fig.6, NTSC video carrier, as an interference wave, generates beat signals with the sine wave signal output from oscillating circuit 20, a reference oscillator, similar to the carrier, that is, a pilot signal, of an intended HDTV channel.

In this case, the operation principle of FPLL 30 for synchronization of frequency and phase is not appropriate and cannot perform the synchronization of carrier of the HDTV channel.

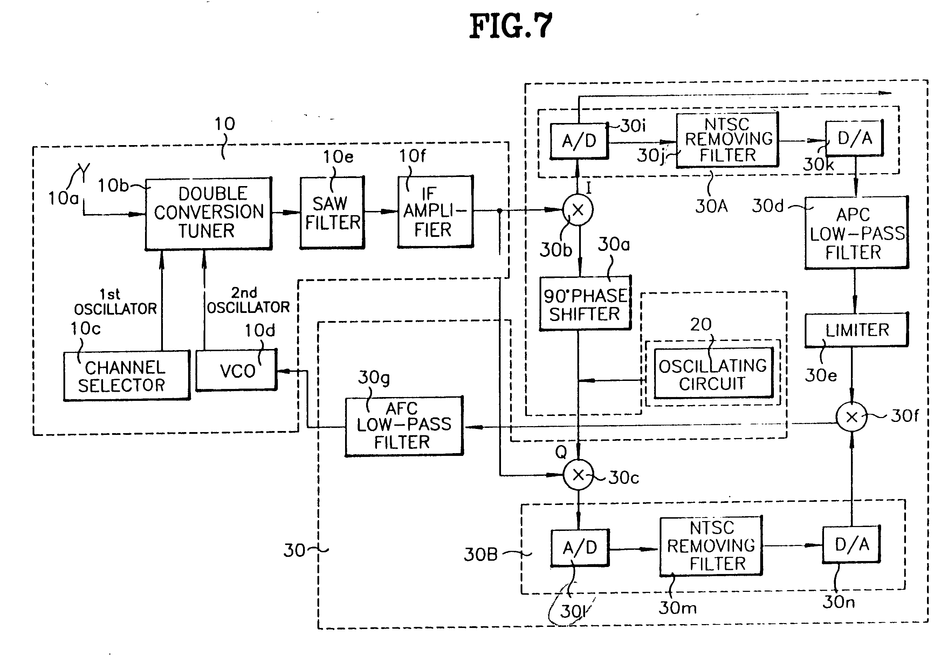

In order to preclude the interference of the NTSC video carrier, America's Zenith proposed an HDTV demodulating system as shown in Fig.7.

This demodulating system is almost the same as but partly different from that of Fig.1.

In the same as the configuration of Fig.1, the demodulating system of Fig.7 comprises tuning circuit 10, oscillating circuit 20 and FPLL 30. This demodulating system further comprises two identical blocks 30A and 30B added to I channel and Q channel of FPLL 30 in order to remove the NTSC video carrier.

Block 30A is inserted between I-channel multiplier 30b and AFC low-pass filter 30d, whereas block 30B is inserted between Q-channel multiplier 30c and multiplier 30f.

Block 30A comprises an A/D converter 30i for converting a beat signal into a digital signal, an NTSC removing filter 30j for removing the NTSC video carrier shown in Fig.6 out of the output signals of A/D converter 30i, and a D/A converter 30k for converting the output signal of NTSC removing filter 30j into an analog signal.

Block 30B for removing the NTSC video carrier in Q channel is also comprised of an A/D converter 30l, an NTSC removing filter 30m and a D/A converter 30n.

NTSC removing filters 30j and 30m, as well-known in the art, is a digital comb filter. For this reason, in order to operate NTSC removing filters 30j and 30m, A/D converters 30i and 30l for digitalizing the I-channel beat signal and Q-channel beat signal are coupled to the respective front ends. D/A converters 30k and 30n are connected to the back ends of NTSC removing filters 30j and 30m in order to process the I-channel beat signal and Q-channel signal from which the NTSC video carrier is removed, in an analog fashion.

In the configuration of Fig.7, in order to remove the interference of NTSC video carrier and improve the performance of FPLL 30, digital processing portions such as D/A converter and A/D converter are added in the FPLL, resulting in complicated hardware. Further, this increases a probability that digital noise is induced to analog noise.

### Summary of the Invention

Particular embodiments of the present invention provide a demodulating system for HDTV which previously removes an information signal excluding an HDTV pilot signal and an NTSC video carrier from an IF signal of HDTV before the IF signal is input to an FPLL, thereby enhancing the performance of the FPLL and not complicating the hardware.

According to a first aspect of the present invention, there is provided a demodulating system for HDTV comprising: a tuning circuit for selecting one out of a plurality of received RF signals and converting the selected signal into an IF signal according to an input loop-controlling signal; an oscillating circuit for generating a sine wave signal; filtering means for passing only a pilot signal containing HDTV carrier information out of the IF signal and canceling the remainder; and FPLL means for performing a predetermined algorithm to form the loop-controlling signal for synchronizing the frequency and phase of the pilot signal and the frequency and phase of the sine wave and providing the loop-controlling signal to the tuning circuit.

### Brief Description of the Drawings

The advantages of the present invention will become more apparent by describing in detail a preferred embodiment thereof with reference to the attached drawings in which:
Fig.1 is a block diagram of a conventional demodulating system for HDTV receiver;
Figs.2A, 2B and 2C are operation waveforms at respective portions of the FPLL shown in Fig.1;
Fig.3A is a circuit diagram of the AFC low-pass filter of Fig.1;
Fig.3B is a frequency characteristic diagram of the AFC low-pass filter of Fig.1;
Fig.4 is an "S" curve diagram showing the characteristic of the FPLL of Fig.1;
Fig.5 is a graph showing the phase synchronizing process of the FPLL shown in Fig.1;
Fig.6 is a diagram of signals contained in low-band signals;
Fig.7 is a block diagram of a conventional demodulating system for HDTV for removing the interference of NTSC video carrier;
Fig.8 is a diagram of the characteristic of the band-pass filter used in a preferred embodiment of the present invention; and
Fig.9 is a block diagram of a demodulating system for HDTV in accordance with a preferred embodiment of the present invention.

### Detailed Description of the Invention

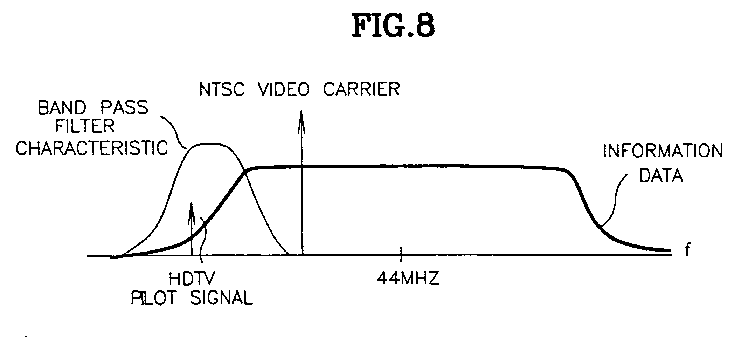

Referring to Fig.8, a low-band signal is basically composed of information data and a pilot signal which is a sine wave signal load on a transmission side. If an NTSC video signal is present on the same channel and there is an interference in an NTSC common channel, an NTSC video carrier is loaded on an information data area of HDTV, as a signal as similarly large as the HDTV pilot signal. Here, for efficient performance of the FPLL, the pilot signal only is required so that other signals should be canceled.

For this purpose, as shown in Fig.8, a filtering means such as a band-pass filter for passing only the pilot signal out of the HDTV IF signal can be tied to the output of the tuning circuit.

The illustrated embodiment uses the characteristic of such a filtering means.

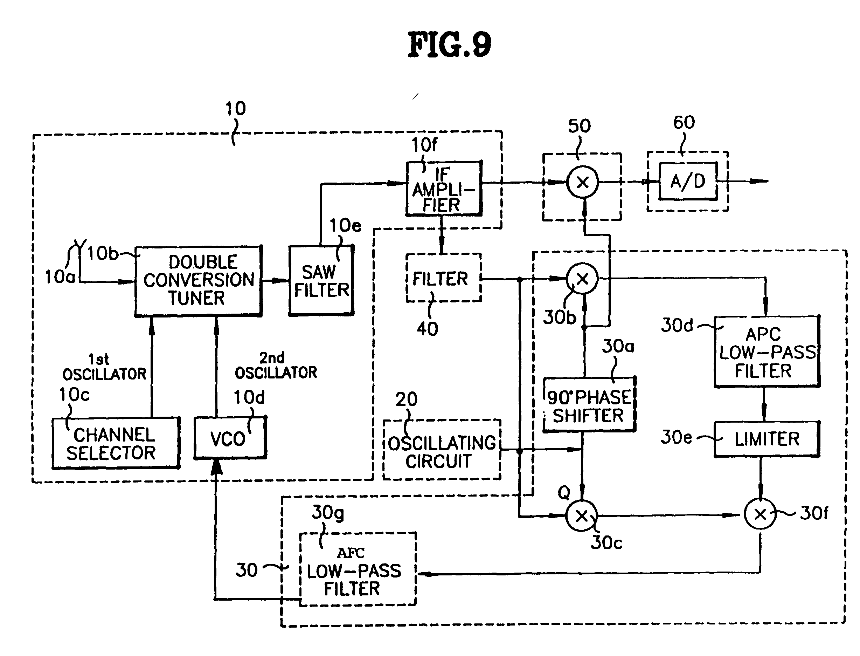

Referring to Fig.9, the demodulating system comprises a tuning system 10 for selecting one out of a plurality of received RF signals and converting the selected signal into an IF signal according to an input loop-controlling signal, an oscillating circuit 20 for generating a sine wave signal, a filtering circuit 40 for passing only a pilot signal containing HDTV carrier information out of the IF signal and canceling the remainder, an FPLL 30 for performing a predetermined algorithm to form a loop-controlling signal for synchronizing the frequency and phase of the pilot signal and the frequency and phase of the sine wave and providing the loop-controlling signal to the tuning circuit 10, a multiplier 50 for multiplying the sine wave signal phase-shifted by a predetermined angle (90°) in FPLL 30 and output from oscillating circuit 20 by the IF signal output from tuning circuit 10 to thereby form a low-band signal, and an A/D converter 60 for converting the low-band signal output from multiplier 50 into a digital signal for the purpose of a succeeding digital signal processing.

Here, the configuration of tuning circuit 10 and FPLL 30 is the same as those of Figs.1 and 7. The detailed description thereof will be omitted.

In Fig.9, a general band-pass filter can be used for filtering circuit 40.

From now on, the operation of the illustrated demodulating system for HDTV will be described in detail.

Out of RF signals received via antenna 10a, one is selected by double conversion tuner 10b according to a first oscillating frequency provided from channel selector 10c, and converted into a first IF signal.

In response to the loop-controlling signal input from double conversion tuner 10b, the frequency of the first IF signal is converted into a second IF signal according to a second oscillating frequency provided from VCO 10d.

The second IF signal is formed into a final IF signal of an adequate magnitude and frequency via SAW filter 10e and IF amplifier 10f.

Here, the output signal of IF amplifier 10f is supplied through two paths.

First, through one path, the final IF signal is multiplied by the sine wave signal output from oscillating circuit 20 (reference oscillator) phase-shifted by 90° by phase shifter 30a of FPLL 30 in multiplier 50. The multiplied signal is converted into a low-band signal.

This low-band signal is converted into a digital signal in A/D converter 60 and provided as the input signal of a succeeding digital signal processing port.

The other case is related only to FPLL 30.

As shown in Fig.8, for FPLL 30 HDTV information data and NTSC video carrier are meaningless. FPLL 30 requires only the pilot signal including HDTV carrier information.

For this reason, if the NTSC broadcasting signal is present in the same channel, it is desirable that the HDTV information data and NTSC video carrier are removed.

In this invention, a band-pass filter, as filtering circuit 40, is coupled to the output port of tuning circuit 10, that is, the output port of IF amplifier 10.

Here, the characteristic of frequency spectrum of the band-pass filter is the result in which only the pilot signal of HDTV is passed and the remainder is canceled as shown in Fig.8. It is not so vital that edges are definitely sharp. Therefore, an expensive band-pass filter is not necessary.

FPLL 30, using the pilot signal passing filtering circuit 40 as an input signal, performs the same algorithm as the conventional FPLL 30 of Figs.1 and 7, thereby providing a loop-controlling signal for synchronizing the phase and frequency of the carrier corresponding to a selected HDTV channel and the phase and frequency of the sine wave signal output from oscillating circuit 20, a reference oscillator, to VCO 10d of tuning circuit 10.

In other words, the sine wave signal output from oscillating circuit 20 and the pilot signal indicative of the carrier output from filtering circuit 40 are converted into I-channel beat signal and Q-channel beat signal both of which are low-band signals, by using phase shifter 30a and multipliers 30b and 30c. The I-channel beat signal is processed through APC low-pass filter 30d and limiter 30e.

The I-channel beat signal output from limiter 30c is multiplied by the Q-channel beat signal in multiplier 30f to thereby form an FPLL controlling signal, i.e., loop-controlling signal. Then, the multiplied signal is fed to VCO 10d of tuning circuit 10 via APC low-pass filter 30g.

In conclusion, the illustrated embodiment yields the following effects.

First, the illustrated embodiment can be used directly for the specification of America's HDTV grand alliance transmission system.

Second, with a band-pass filter being inserted on the output side of the IF signal, the jitter of FPLL can be reduced by previously removing unnecessary information data excluding a pilot signal.

Third, even if a common channel interference is present in a low-band HDTV signal due to an NTSC broadcasting signal, the interference can be simply canceled with an analog band-pass filter tied to the IF signal output port. This simplifies the conventional process in which the low-band signal passes an A/D converter, a digital comb filter as an NTSC removing filter, and a D/A converter. Further, this simplifies the configuration of FPLL.

Fourth, there is no need of the digital comb filter and D/A converter. This does not produce the possibility of noise creation due to the mingling of digital signal and analog signal.

## Claims

1. A demodulating system for HDTV comprising:
a tuning circuit (10) for selecting one out of a plurality of received RF signals and converting the selected signal into an IF signal according to an input loop-controlling signal;
an oscillating circuit (20) for generating a sine wave signal;
filtering means (40) for passing only a pilot signal containing HDTV carrier information out of said IF signal and cancelling the remainder; and FPLL means (30) for performing a predetermined algorithm to form the loop-controlling signal for synchronizing the frequency and phase of said pilot signal and the frequency and phase of said sine wave and providing said loop-controlling signal to said tuning circuit.

2. A demodulating system for HDTV as claimed in claim 1, further comprising:
a multiplier (50) for multiplying said sine wave signal phase-shifted by a predetermined angle in said FPLL means and output from said oscillating circuit (20) by the IF signal output from said tuning circuit (10), thereby forming a low-band signal; and
an A/D converter (60) for converting said low-band signal output from said multiplier (50) into a digital signal for the purpose of a succeeding digital signal processing.

3. A demodulating system for HDTV as claimed in claim 1, wherein said FPLL means (30) provides a loop-controlling signal by fixing the frequency and phase of said sine wave signal output from said oscillating circuit (20) and varying the phase and frequency of the pilot signal containing the carried output from said filtering means (40).

4. A demodulating system for HDTV as claimed in claim 1, wherein said filtering means (40) is a band-pass filter.

5. A demodulating system for HDTV as claimed in claim 1, wherein said tuning circuit (10) comprises:
an antenna (10a) for receiving a plurality of RF signals;
a double conversion tuner (10b) ;
a channel selector (10c) for serving as a first oscillator for, according to a user's selection, selecting one of said RF signals received by said double conversion tuner and converting the selected carrier into a first intermediate frequency signal;
a voltage controlled oscillator (10d) for serving as a second oscillator for converting said first intermediate frequency signal into a second intermediate frequency signal of a frequency band easy to handle in a general circuit;
a SAW filter (10e) for filtering the second intermediate frequency signal output via said tuner; and
an IF amplifier (10f) for amplifying the second intermediate frequency signal output from said SAW filter.

6. A demodulating system for HDTV as claimed in claim 1, wherein said FPLL (30) comprises:
a phase shifter (30a) for shifting the phase of said sine wave output from said oscillating circuit (20) by a predetermined angle;
a multiplier (30b) for multiplying the second intermediate frequency signal output from said tuning circuit (10) by the output signal of said phase shifter (30a) and outputting the multiplication result as an I-channel best signal;
a multiplier (30c) for multiplying said sine wave signal output from said oscillating circuit by the second intermediate frequency signal output from said tuning circuit and outputting the result as Q-channel best signal;
an automatic phase control (30d) low-pass filter for passing only a predetermined low band of a signal out of said I-channel beat signal and changing the phase of the signal according to the frequency of said I-channel best signal;
a limiter (30e) for amplifying and limiting the output signal of said APC low-pass filter to a predetermined amplification degree;
a multiplier (30f) for multiplying the output signal of said multiplier (30c) by the output signal of said limiter; and
an automatic frequency control low-pass filter (30g) for passing only a predetermined low frequency band of signal out of the output signal of said multiplier (30f) and providing the passed signal to said VCO (10d) of said tuning circuit (10) as a loop-controlling signal for correcting the frequency of a selected carrier into an intended frequency.

## Patentansprüche

1. Demodulationssystem für HDTV, umfassend:
eine Abstimmschaltung (10) zum Auswählen eines aus einer Mehrzahl von empfangenen RF-Signalen und zum Umwandeln des ausgewählten Signals in ein IF-Signal gemäß eines Eingangsschleifensteuersignals;
eine Schwingschaltung (20) zum Erzeugen eines Sinuswellensignals;
Filtermittel (40) zum ausschließlichen Durchgang einer ein Pilotsignal enthaltenden HDTV-Trägerinformation aus dem IF-Signal und zum Löschen des Rests; und
FPLL-Mittel (30) zum Ausführen eines vorbestimmten Algorithmus, um das Schleifensteuersignal zum Synchronisieren der Frequenz und der Phase des Pilotsignals sowie der Frequenz und Phase der Sinuswelle zu bilden, und zum Bereitstellen des Schleifensteuersignals an die Abstimmschaltung.

2. Demodulationssystem für HDTV gemäß Anspruch 1, ferner umfassend:
einen Vervielfacher (50) zum Vervielfachen des Sinuswellensignals, das um einen vorbestimmten Winkel in den FPLL-Mitteln phasenverschoben und von der Schwingschaltung (20) durch das IF-Signal ausgegeben wird, das seinerseits von der Abstimmschaltung (10) ausgegeben wird, wodurch ein Tiefbandsignal ausgebildet wird; und
einen A/D-Umwandler (60) zum Umwandeln des Tiefbandsignals, das vom Vervielfacher (50) ausgegeben wird, in ein digitales Signal zum Zwecke einer nachfolgenden digitalen Signalverarbeitung.

3. Demodulationssystem für HDTV gemäß Anspruch 1, wobei die FPLL-Mittel (30) ein Schleifensteuersignal durch Festsetzen der Frequenz und Phase des Sinuswellensignals bereitstellt, das von der Schwingschaltung (20) ausgegeben wird, und Verändern der Phase und Frequenz des den Träger umfassenden Pilotsignals, das von den Filtermitteln (40) ausgegeben wird.

4. Demodulationssystem für HDTV gemäß Anspruch 1, wobei die Filtermittel (40) ein Bandpassfilter sind.

5. Demodulationssystem für HDTV gemäß Anspruch 1, wobei die Abstimmschaltung (10) umfasst:
eine Antenne (10a) zum Empfangen einer Mehrzahl von RF-Signalen;
eine Doppelüberlagerungsabstimmvorrichtung (10b) ;
- einen Kanalauswähler (10c), um als erste Schwingschaltung zur, gemäß einer Auswahl des Benützers, Auswahl eines der RF-Signale zu dienen, die von der Doppelüberlagerungsabstimmvorrichtung empfangen werden, und um den ausgewählten Träger in ein erstes Zwischenfrequenzsignal umzuwandeln;
eine spannungsgeregelte Schwingschaltung (10d), um als eine zweite Schwingschaltung zum Umwandeln des ersten Zwischenfrequenzsignals in ein zweites Zwischenfrequenzsignal eines Frequenzbandes zu dienen, das leicht in einer allgemeinen Schaltung handhabbar ist;
einen SAW-Filter (10e) zum Filtern des zweiten Zwischenfrequenzsignals, das über die Abstimmvorrichtung ausgegeben wird; und
einen IF-Verstärker (10f) zum Verstärken des zweiten Zwischenfrequenzsignals, das vom SAW-Filter ausgegeben wird.

6. Demodulationssystem für HDTV gemäß Anspruch 1, wobei die FPLL-Mittel (30) umfassen:
einen Phasenschieber (30a) zum Verschieben der Phase der Sinuswelle, die von der Schwingschaltung (20) um einen vorbestimmten Winkel ausgegeben wird;
einen Vervielfacher (30b) zum Vervielfachen des zweiten Zwischenfrequenzsignals, das von der Abstimmschaltung (10) ausgegeben wird, mit dem ausgegebenen Signal des Phasenschiebers (30a) und Ausgeben des Vervielfachungsergebnisses als ein bestes Signal des I-Kanals;
einen Vervielfacher (30c) zum Vervielfachen des - Sinuswellensignals, das von der Schwingschaltung ausgegeben wird, mit dem zweiten Zwischenfrequenzsignal, das von der Abstimmschaltung ausgegeben wird, und Ausgeben des Ergebnisses als bestes Signal des Q-Kanals;
einen Tiefpassfilter zur automatischen Phasensteuerung (30d) zum ausschließlichen Durchlassen eines vorbestimmten Tiefbands eines Signals aus dem besten Signal des I-Kanals und zum Verändern der Phase des Signals gemäß der Frequenz des besten Signals des I-Kanals;
einen Begrenzer (30e) zum Verstärken und Begrenzen des Ausgabesignals des APC-Tiefpassfilters um einen vorbestimmten Verstärkungsgrad;
einen Vervielfacher (30f) zum Vervielfachen des Ausgabesignals des Vervielfachers (30c) mit dem Ausgabesignal des Begrenzers; und
einen Tiefpassfilter zur automatischen Frequenzsteuerung (30g) zum ausschließlichen Durchlassen eines vorbestimmten Niederfrequenzbandes eines Signals aus den Ausgabesignalen des Vervielfachers (30f) und zum Bereitstellen des durchgelassenen Signals am VCO (10d) der Abstimmschaltung (10) als ein Schleifensteuersignal zum Korrigieren der Frequenz eines ausgewählten Trägers in eine beabsichtigte Frequenz.

## Revendications

1. Un système de démodulation pour télévision haute définition (TVAD) comprenant :
- un circuit d'accord (10) pour sélectionner un parmi une pluralité de signaux à fréquence radio reçu et convertir le signal sélectionné en un signal à fréquence intermédiaire en fonction d'un signal d'entrée à commande de boucle;
- un circuit oscillant (20) pour générer un signal sinusoïdal;
- des moyens de filtrage (40) laissant passer uniquement un signal pilote qui contient des informations de porteuse TVHD à partir dudit signal à fréquence intermédiaire, et pour annuler le reste; et
- des moyens formant une boucle asservissement de phase et de fréquence FPLL (30) pour l'exécution d'un algorithme prédéterminé pour former le signal de commande de boucle pour la synchronisation de la fréquence et de la phase dudit signal pilote et de la fréquence et la phase dudit signal sinusoïdal et fournir ledit signal de commande de boucle audit circuit d'accord.

2. Un système de démodulation pour télévision à haute définition selon la revendication 1, comprenant:
- un multiplicateur (50) pour multiplier ledit signal sinusoïdal décalé en phase d'un angle prédéterminé, dans lesdits moyens FPLL, et fourni en sortie par ledit circuit oscillant (20) par le signal à fréquence intermédiaire fourni en sortie par ledit circuit d'accord (10), pour ainsi constituer un signal à bande basse; et
- un convertisseur A/D (60) pour convertir ledit signal en bande basse fourni en sortie par ledit multiplicateur (50) en un signal numérique pour le traitement d'un signal numérique qui succède.

3. Un système de démodulation pour télévision à haute définition selon la revendication 1 dans lequel les dits moyens FPLL (30) fournissent un signal de commande de boucle par fixation de la fréquence et de la phase dudit signal sinusoïdal fourni en sortie par ledit circuit oscillant (20) et en variant la phase et la fréquence dudit signal pilote qui contient la sortie de porteuse des dits moyens de filtrage (40).

4. Un système de démodulation pour télévision à haute définition selon la revendication 1, dans lequel lesdits moyens de filtrage (40) sont un filtre passe-bande.

5. Un système de démodulation pour télévision à haute définition selon la revendication 1, dans lequel ledit circuit d'accord (10) comprend:
- une antenne (10a) pour recevoir une pluralité de signaux à fréquence radio;
- un syntoniseur à double conversion (10b);
- un sélecteur de canal (10c) pour servir de premier oscillateur pour choisir, en correspondance avec une sélection de l'utilisateur, un parmi lesdits signaux à fréquence radio reçus par ledit syntoniseur à double conversion et pour convertir la porteuse choisie en un premier signal à fréquence intermédiaire;
- un oscillateur commandé en tension (10d) pour servir de deuxième oscillateur pour convertir ledit premier signal à fréquence intermédiaire en un deuxième signal à fréquence intermédiaire dans une bande de fréquence facile à traiter dans un circuit général;
- un filtre à ondes acoustiques de surface (10e) pour filtrer le deuxième signal à fréquence intermédiaire fourni en sortie par ledit syntoniseur;
- un amplificateur à fréquence intermédiaire (10f) pour amplifier le deuxième signal à fréquence intermédiaire fourni en sortie par ledit filtre à ondes acoustiques de surface.

6. Un système de démodulation pour télévision à haute définition selon la revendication 1, dans lequel ladite boucle FPLL (30) comprend:
- un décaleur de phase (30a) pour décaler la phase dudit signal sinusoïdale fourni en sortie par ledit circuit oscillateur (20) d'un angle prédéterminé;
- un multiplicateur (30b) pour multiplier le deuxième signal à fréquence intermédiaire fourni en sortie par ledit circuit d'accord (10) par le signal fourni en sortie par ledit décaleur de phase (30a) et pour fournir en sortie le résultat de la multiplication en tant que signal de battement pour le canal I (en phase);
- un multiplicateur (30c) pour multiplier ledit signal sinusoïdale fourni en sortie par ledit circuit oscillateur par le deuxième signal à fréquence intermédiaire fourni en sortie par ledit circuit d'accord et pour fournir en sortie le résultat en tant que signal de battement de canal Q (en quadrature);
- un filtre passe -basse de commande de phase automatique (30d) ne passant que une bande basse prédéterminée d'un signal venant dudit signal de battement de canal I et pour changer la phase du signal en fonction de la fréquence dudit signal de battement de canal I;
- un limiteur (30e) pour amplifier et pour limiter le signal de sortie dudit filtre passe-bas à commande de phase automatique à un degré d'amplification prédéterminé;
- un multiplicateur (30f) pour multiplier le signal de sortie dudit multiplicateur (30c) par le signal de sortie dudit limiteur; et
- un filtre passe-bas de commande automatique de fréquence (30g) pour ne passer qu'une bande à basse fréquence prédéterminée du signal de sortie dudit multiplicateur (30f) et pour foumir le signal qui est passé au dit oscillateur VCO (10d) dudit circuit d'accord (10) en tant que signal de commande de boucle pour corriger la fréquence d'une porteuse sélectionnée pour obtenir une fréquence souhaitée.
